# EUROPEAN PATENT SPECIFICATION

(11) **EP 1 560 222 B1**
(45) Date of publication and mention of the grant of the patent: **15.07.2009**
(21) Application number: 04290251.0
(22) Date of filing: 30.01.2004
(51) Int. Cl.: G11C 11/00

(54) **Method for producing a combined RAM and ROM device**
Verfahren zur Herstellung eines kombinierten RAM und ROM Speichers
Procédé de fabrication d'une mémoire SRAM et ROM combinée

(43) Date of publication of application: 03.08.2005
(73) Proprietor: Infineon Technologies AG, 81669 München (DE)
(72) Inventor: Fernandez Sanchez, Marta, 06600 Antibes (FR); Bretegnier, Damien, Whitefield Road Bangalore 560 066 (IN); Buy, Jean-Christophe, 06600 Antibes (FR)
(74) Representative: Banzer, Hans-Jörg

(56) References cited:
- US-A- 5 365 475
- US-A- 5 675 547
- US-A- 6 041 008
- US-A- 6 128 218

## Description

The present invention relates to a method for producing a memory device and a memory device, in particular a hybrid SRAM/ROM device.

In semiconductor memory devices basically two types of memory are used. One is a so called Read-Only-Memory (ROM) which is a non-volatile memory only accessible to read operations, i.e. the information stored in such a memory is permanent and changing of this information is typically not possible or requires a special treatment. The other type is a so called Random-Access-Memory (RAM) which is accessible to both read and write operations, i.e. information stored in such a memory can be changed by performing said write operations.

In computer systems both types of memory are necessary for providing instructions and data to the computer system or for temporarily storing data during processing. Typically RAM and ROM devices are provided separately in the computer system. This can be on separate semiconductor chips or on a single chip which comprises different arrays of memory cells for RAM and ROM devices. The latter situation is particularly relevant in case of microprocessors, which typically contain different types of semiconductor circuitry including RAM and ROM on a single chip.

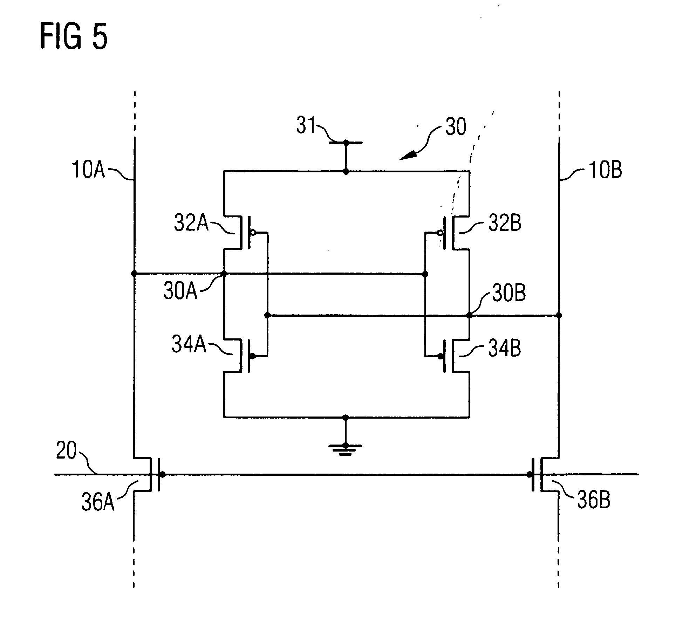

A typical example of a RAM cell is the so called SRAM (Static Random Access Memory) cell, of which an exemplary representation is shown in Fig. 5. As a storage device the SPAM cell comprises a bistable semiconductor circuit 30 consisting of four transistors. In the SRAM cell of Fig. 5 the storage device 30 comprises PMOS field effect transistors 32A, 32B and NMOS field effect transistors 34A, 34B. A high voltage potential, i.e. a positive supply voltage of the bistable semiconductor circuit, is provided at supply node 31. A connection of the supply node 31 to a low voltage potential, i.e. a ground potential, is provided via the transistors 32A and 34A on one side and the transistors 32B and 34B on the other side. A node between the transistors 32A and 34A and the gates of transistors 32B and 34B are connected to a bit line 10A. Similarly, a node 30B between transistors 32B and 34B and the gates of transistors 32A and 32B are connected to a complementary bit line. In the bit line 10A and the complementary bit line 10B switching transistors 36A and 36B, respectively, are provided for connecting the storage device 30 to precharging means and a write device (not shown). The gates of the switching transistors 36A and 36B are connected to a word line 20 for controlling the switching transistors.

For storing information in the SRAM cell, i.e. a write operation, the bit line 10A and the complementary bit line 10B are connected to different potentials, i.e. the bit line 10A to the high voltage potential and the complementary bit line to the low voltage potential for storing a logic "1", or the bit line 10A to the low voltage potential and the complementary bit line 10B to the high voltage potential for storing a logic "0". In the first case, i.e. for the logic "1", transistors 32A and 34B are switched to their open state, while transistors 32B and 34A are switched to their closed state. In this state of the bistable semiconductor circuit the gates of the transistors 32B and 34B are connected to the high voltage potential at the supply node 31, while the gates of the transistors 32A and 34A are connected to the low voltage potential. Hence, this state remains stable even if the bit line 10A and complementary bit line 10B are disconnected from the storage device by means of the switching transistors 36A and 36B, i.e. the information is stored in the SRAM cell. In the second case, i.e. for the logic "0", the transistors 32B and 34A are switched to their open state, while transistors 32A and 34B are switched to their closed state. In this state of the bistable semiconductor circuit the gates of the transistors 32A and 34A are connected to the high voltage potential at the supply node 31, while the gates of the transistors 32B and 34B are connected to the low voltage potential. Again, a state is achieved which remains stable even if the bit line 10A and complementary bit line 10B are disconnected from the storage device by means of the switching transistors 36A and 36B, i.e. the information is stored.

For retrieving information from the SRAM cell, i.e. a read operation, the bit line 10A and the complementary bit line 10B are both precharged to a predetermined value, i.e. such that they are at a potential essentially corresponding to the high voltage potential, by the precharging means. Then the storage device is temporarily connected to the bit line 10A and complementary bit line 10B by means of the switching transistors 36A and 36B controlled by the word line 20. The resulting voltage drop on the bit line 10A and the complementary bit line 10B is measured by a suitable detection means. If transistor 32A is in a closed state and transistor 34A is in an open state, i.e. if a logic "0" has been stored in the memory cell in above-described write operation, the bit line 10A is temporarily connected to the low voltage potential and a voltage drop occurs. On the other hand, due to the state of transistors 32B and 34B, the complementary bit line 10B is temporarily connected to the high voltage potential and no voltage drop occurs on the complementary bit line 10B. Similarly, if a logic "1" has been stored in the SRAM cell, a voltage drop occurs on the complementary bit line 10B and not on the bit line 10A. Consequently, the state of the bistable semiconductor circuit of the storage device can be determined by suitably evaluating the voltage drop on the bit line 10A and complementary bit line 10B.

In an SRAM device typically a large number of such SRAM cells are arranged in an array, i.e. rows and columns, and the SRAM cells are addressed by a common read and write logic, common precharging means and common detection means.

In contrast to the above-described SRAM cells, the state of ROM cells can not be changed in a write operation. Accordingly, ROM devices typically have an architecture which is different from a RAM device and are provided in separate arrays.

Providing RAM and ROM devices separately, however, occupies a large amount of space, which is a problem in particular in the case of microprocessors, which contain arrays of RAM and arrays of ROM cells on a single semiconductor chip. The space requirements result in a large semiconductor chip size which adversely affects the performance of the microprocessor. Further, the separate arrays lead to a complex circuit structure which increases efforts in development and production of the semiconductor chip. For example, a read out logic has to be provided separately for each of the memory arrays. This also means that during design a so called place and route step in which circuit components are placed on the semiconductor chip and connections between the components are "routed" is complicated. Hence, in most cases it is not possible to efficiently use the area available on the semiconductor chip.

In view of the above problems US Patent No. 6,438,024 B1 discloses a memory device, which combines RAM and ROM devices into a single memory array. The memory array contains two different types of memory cells, one type of memory cell for the RAM, essentially corresponding to conventional RAM cells, and a second type of memory cell for the ROM. The ROM cells are designed to be read out by the same read out logic as used for the RAM cells.

While the above approach of combining RAM cells and ROM cells to a single array reduces space requirements and also simplifies the circuit structure, it requires two different types of memory cells, i.e. one type of memory cell for the RAM and one type of memory cell for the ROM. This means that two different cell libraries have to be used when designing the semiconductor chip. Further, when the information to be stored in the ROM cells needs to be changed, for example in case of an error, a complex redesign of the circuit structure and production process is required. In such a case it is required to modify or redesign at least some of the lithography masks used for processing the semiconductor chip. This means, with such a memory device there is a lack of flexibility.

In US 5,365,475, a semiconductor memory device is described which is usable as SRAM-memory and as ROM-memory. In this hybrid-type memory device memory cells are used which can be configured to function as SRAM-memory cells or as ROM-memory cells by providing connections to predetermined potentials. Establishing the connections can be accomplished either during manufacture of the memory device or during operation of the memory device by selectively applying a potential to corresponding potential lines. In any case, an additional process step for establishing the connections to the potential lines is necessary, as without the connections the memory cell is not operable, i.e. not suitable for storing and retrieving information.

In US 6,041,008, a method and apparatus for embedded read only memory in static random access memory are disclosed. By disabling or not disabling SRAM cells by removing or not removing the ground or power connection to each cell in different combinations, a pair of SRAM cells can be modified to function as a ROM cell. Alternatively, a single SRAM cell and a reference signal can be programmed to function as a ROM cell.

In US 6,128,218, a hybrid memory device is disclosed. The hybrid memory device comprises a RAM cell and a ROM cell that separately operate, and is capable of loading data in the ROM cell into the RAM cell. The ROM cell can be programmed by means of fuses.

It is an object of the present invention to provide a method for producing memory devices and a memory device which do not suffer from the above problems and in particular simplify the production of a semiconductor chip containing either RAM or ROM or a combination of RAM and ROM.

This object is achieved by a method according to claim 1 and a memory device according to claim 4. The dependent claims define preferred and advantageous embodiments of the invention.

According to the present invention, a method for producing a memory device comprises providing memory cells, each comprising a storage device for storing information in said memory cell. The storage device is designed such that information can be stored in a memory cell in a write operation and the information can be retrieved from the memory cell in a read operation. These memory cells correspond SRAM cells with a storage device in the form of a bistable semiconductor circuit. According to the method of the invention an additional process step is performed on the memory device for physically modifying the storage devices of a number of memory cells to assign predetermined information to said number of the memory cells such that the predetermined information can permanently be retrieved from the memory cell in said read operation. This means that the predetermined information is permanently stored in said number of memory cells which then essentially correspond to ROM cells.

By means of this method a memory device comprising both RAM and ROM cells can be produced in a very efficient way. In particular, the method is based on providing memory cells essentially corresponding to RAM cells. Only by means of an additional process step predetermined information is assigned to these memory cells such that they essentially correspond to ROM cells. This means that for changing the predetermined information permanently stored in the memory cells only the additional process step has to be changed and no redesigning of the memory device is required.

The additional process step may be omitted when producing a memory device exclusively consisting of memory cells corresponding to RAM cells, i.e. an SRAM device, and the production of the memory device is further simplified.

The additional process step comprises physically modifying a semiconductor circuit of the storage device. This may for example be achieved by providing a metalization selectively covering parts of the memory device. By means of the metalization an additional connection of components of the semiconductor circuit of the storage device can be achieved such that the function of the storage device is modified and the read operation on the memory cell containing the storage device always provides the same predetermined information, i.e. the information is permanent. The additional connection is a connection to a low voltage potential, such as a ground potential, or a high voltage potential, such as a positive supply voltage of the semiconductor circuit of the storage device.

Alternatively the additional process step may comprise selectively doping parts of the memory device, for example by ion implantation. Similar to the metalization, the selective doping can be performed such that an additional connection is established between components of the semiconductor circuit of the storage device, in order to modify the function of the storage device to permanently provide the predetermined information.

According to the present invention, a memory device comprises a storage device with a semiconductor circuit for storing information in said memory cell. The memory cells essentially correspond to SRAM cells. In the memory device according to the present invention, at least one of the memory cells, the semiconductor circuit of the storage device is physically modified to comprise an additional connection as compared to the other, unmodified memory cells, in order to assign predetermined information to the number of memory cells such that the predetermined information can permanently be retrieved from the number of memory cells in said read operation. For the other, unmodified, memory cells the storage device is capable of storing information in said memory cell in a write operation such that the information can be retrieved from the memory cell in said read operation. Hence, the other memory cells essentially correspond to RAM cells. The modified memory cells permanently provide the predetermined information, i.e. they correspond to ROM cells.

The memory device of the invention offers the advantage that in an evaluation phase, for example of a microprocessor, the memory device may be provided without adding or removing the connections, i.e. as a RAM device. In this case information in the memory device can be easily changed for evaluation purposes. When suitable information or data, such as program code, has been evaluated, a memory device in which this information is permanently stored can easily be provided by correspondingly adding or removing the connections, without having to modify a design or layout of the memory device. Hence, the memory device of the present invention greatly simplifies the evaluation of a device such as a microprocessor.

The memory device of the present invention is a hybrid SRAM/ROM device, i.e. it comprises memory cells essentially corresponding to SRAM cells a number of which has been modified according to the invention to function as ROM cells.

The present invention greatly simplifies producing memory devices, in particular when both RAM and ROM has to be provided to a device, such as a microprocessor. A main advantage of the invention is that is offers flexibility for evaluation of the device provided with the memory device by being able to first provide a RAM device for evaluating suitable information or data to be permanently stored in ROM and then provide a ROM device or combined RAM/ROM device (hybrid device) in which the evaluated information is permanently stored, preferably by adding or removing connections in an additional process step, without having to further modify the layout or design of the memory device.

By the combination of RAM and ROM, only one shared memory logic is necessary, which reduces the complexity of the memory device and at the same time keeps space requirements at a minimum. Also as only one type of memory cell is used, the memory device can be provided with a very uniform structure and its components can be placed more densely on a semiconductor chip.

Furthermore, no different processes are needed to produce RAM devices, ROM devices or hybrid devices. Only the information to be permanently stored has to be provided. If no information is permanently stored, the resulting memory device corresponds to a RAM device.

With the present invention, a memory device with changed or updated permanently stored information can be easily provided by only modifying the additional process step, such as a metalization mask.

In the following, a preferred embodiment of the invention will be explained in detail with reference to the accompanying drawings.
Fig. 1 is a schematic representation of a memory device according to an embodiment of the present invention;
Fig. 2 schematically illustrates a method according to an embodiment of the present invention;
Fig. 3 is a schematic representation of a memory cell used in the memory device of Fig. 1;
Fig. 4A and 4B are more detailed representations of the memory cell in Fig. 3, to which a logic "0" or a logic "1" has been assigned, respectively; and
Fig. 5 is an example of a typical SRAM cell used as a basis for the memory cells of Fig. 4A and 4B.

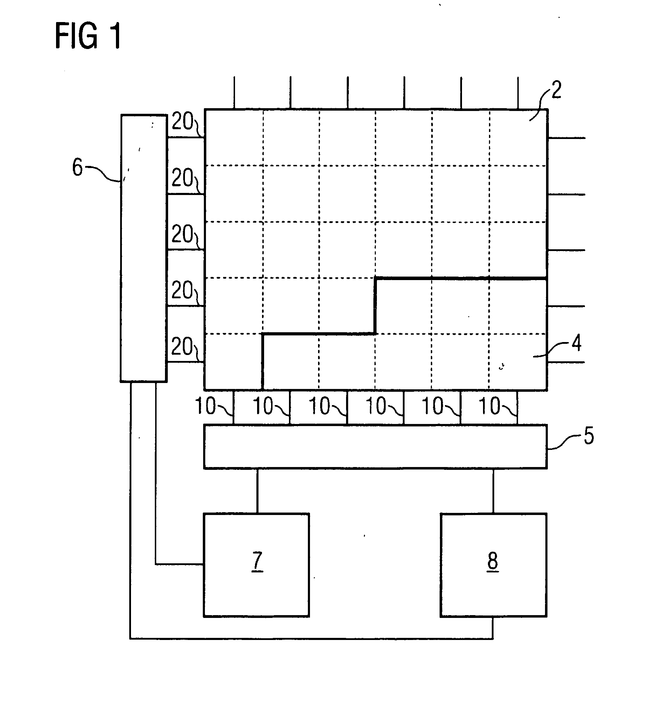

Fig. 1 is a schematic representation of a memory device according to an embodiment of the present invention. The memory device is a hybrid SRAM/ROM device, i.e. it includes SRAM memory cells 2 and modified memory cells corresponding to ROM cells 4. The SRAM memory cells 2 and ROM cells 4 are arranged in a single array and are both addressed by bit lines 10 and word lines 20. The bit lines 10 actually each consist of a bit line and a complementary bit line (not shown).

For performing read operations and write operations on the memory cells 2, 4, the bit lines 10 and word lines 20 are connected a write logic or write device 8, and a read logic or read device 7, which address all memory cells 2, 4 of the array. The read device 7 may in particular include precharging means and suitable detection means. The read device 7 and the write device 8 are connected to the memory array via a word line logic 6 and a bit line logic 5.

In the memory device of Fig. 1 predetermined information has been assigned to a number of the memory cells 2, 4, which form the ROM cells 4. The ROM cells 4 can be located at any position of the array. A solid line in Fig. 1 exemplarily divides the array area used for SRAM cells 2 and the array area used for ROM cells 4.

The ROM cells 4 in the memory device of Fig. 1 are essentially of the same type as the SRAM cells 2, only that on the ROM cells 4 an additional process step has been performed when producing the memory device, in order to assign predetermined information to the ROM cells 4.

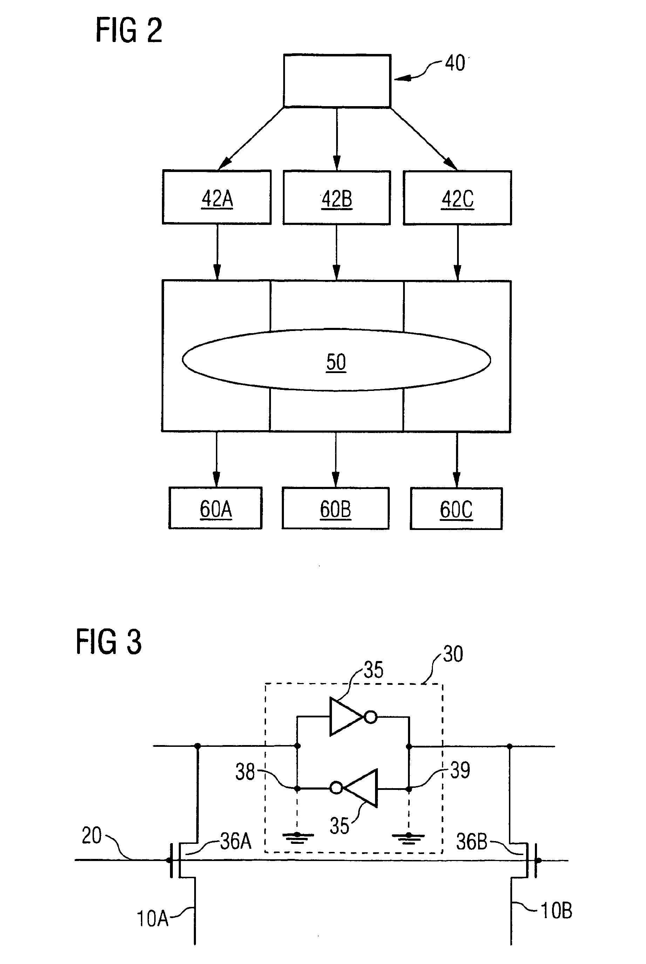

Fig. 2 schematically illustrates the method according to an embodiment of the present invention. The method comprises providing memory cells, whereby each of the memory cells comprises a storage device designed for storing information in said memory cell. The storage device is designed such that the information can be stored in said memory cell in a write operation and the information can be retrieved from the memory cell in a read operation. The method further comprises providing a read device and a write device such that memory devices can be created which correspond to RAM devices. In the illustrated embodiment, the memory cells provided by the method essentially correspond to SRAM cells. As illustrated by Fig. 2, a memory generator 50, which may be a system for producing memory devices, a system for developing the total process for producing the memory device, or a system for controlling equipment for producing a memory device, is provided with data or predetermined information to be permanently stored in the memory device (input 40). For assigning predetermined information to a number of the SRAM cells a corresponding additional process step is performed.

The predetermined information may be information to be assigned to all of the SRAM cells (case 42A), information to be assigned to a part of the SRAM cells (case 42B), or no information which is to be assigned to the SRAM cells (case 42C).

When producing the memory device, the memory generator 50 performs the additional process step, which has been adapted to assign the predetermined information to the SRAM cells. In the additional process step a modification of the SRAM cells is accomplished such that the read operation on the modified SRAM cells provides the predetermined information.

In case 42A of information which is to be assigned to all the SRAM cells, the resulting memory device corresponds to a ROM device (result 60A). In case 42B of information to be assigned to a part of the SRAM cells, the resulting memory device comprises both SRAM and ROM cells (result 60B). In case 42C of no information which is to be assigned to the SRAM cells, the resulting memory device corresponds to a SRAM device (result 60C). For producing the different types of memory devices only the additional process step is modified. Also, for providing different predetermined information to be permanently stored in the memory device only the additional process step is modified.

Further, the memory generator 50 checks whether predetermined information is to be assigned to at least one of the SRAM cells. If this is not the case, i.e. in case 42C of Fig. 2, the additional process step is omitted. By this means processing of the memory device is minimized.

The additional process step performed on the memory device provides a metalization covering parts of the memory device and establishing additional connections between semiconductor circuit components of the SRAM cells. Alternatively, the additional process step may also comprise selectively doping areas of the semiconductor circuits of the SRAM cells in order to establish the additional connections. The additional process step may also be a combination of the above-mentioned measures.

The additional process step is performed at a suitable stage of the total process for producing the memory device. This stage is typically an intermediate stage, such as after the basic structures of the memory device have been completed, but are not yet covered by an oxide layer.

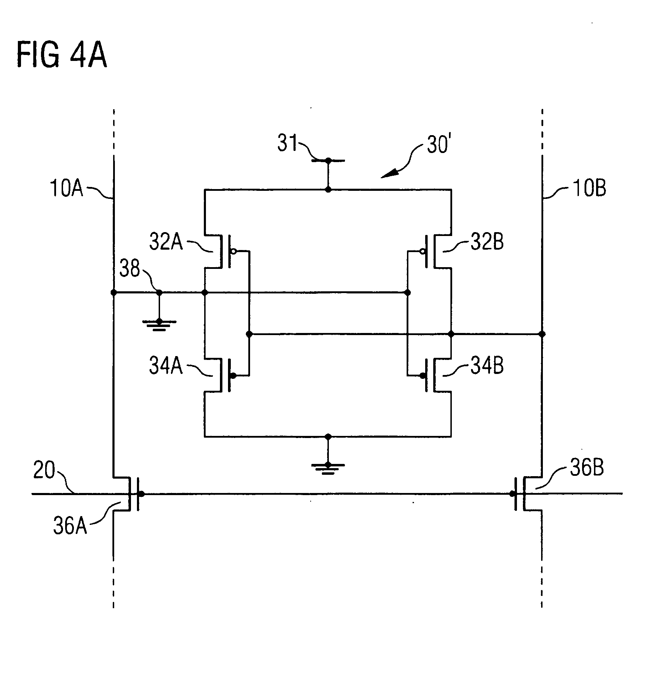

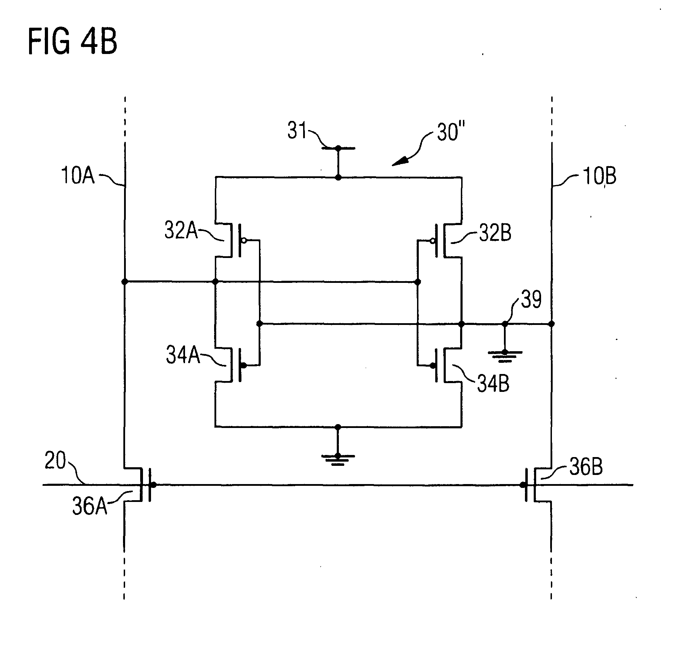

In the following, the modifications of the SPAM cells, which are effected by the additional process step, will be explained with reference to Figs. 3, 4A and 4B.

Fig. 3 is a schematic representation of a memory cell used in the memory device of Fig. 1, essentially corresponding to a typical SRAM cell as discussed above with reference to Fig. 5. The memory cell comprises a storage device 30 with two inverters 35. The storage device 30 is connected between a bit line 10A and a complementary bit line 10B and can be connected to these by switching transistors 36A and 36B. The switching transistors are controlled by a word line 20.

In the additional process step an additional connection is established in the semiconductor circuit of the storage device 30. This connection is denoted by broken lines starting from nodes 38 or 39 in Fig. 3. In particular, for assigning a logical "0" to the SRAM cell of Fig. 3, a connection between the node 38 and a low voltage potential, i.e. a ground potential, is established. For assigning a logical "1" to the SRAM cell of Fig. 3 a connection of the node 39 to the low voltage potential is established.

By this means it is achieved that when a read operation is carried out on the memory cell, i.e. the bit line 10A and the complementary bit line 10B are precharged to a high voltage potential and temporarily connected to the storage device 30, a voltage drop always occurs on the same of the bit line 10A and the complementary bit line 10B. In particular, a voltage drop always occurs on the bit line 10A, when the additional connection is established between the node 38 and the low voltage potential, and the voltage drop always occurs on the complementary bit line 10B, when the additional connection is established between the node 39 and the low voltage potential.

A more detailed implementation of the memory cell shown in Fig. 3 is illustrated in Figs. 4A and 4B. The components and structure of the memory cell essentially correspond to the components discussed above with reference to Fig. 5, i.e. the memory cell comprises PMOS field effect transistors 32A, 32B, NMOS field effect transistors 34A, 34B, and switching transistors 36A,36B. A high voltage potential, i.e. a positive supply voltage of the semiconductor circuit of the storage device, is provided at supply node 31. To the memory cell of Fig. 4A a permanent logic "0" has been assigned and to the memory cell of Fig. 4B a permanent logic "1" has been assigned.

From Figs. 4A and Figs. 4B it becomes clear, that by providing the additional connection at the node 38 or 39, respectively, not only a voltage drop always occurs on either the bit line 10A or the complementary bit line 10B, but also a voltage drop on the other of the bit line 10A and the complementary bit line 10B is prevented. This means that, if the additional connection is provided from the node 38 to the low voltage potential as shown in Fig. 4A, the gates of the transistors 32B and 34B are also connected to the low voltage potential such that transistor 32B is in an open state while transistor 34B is in a closed state. Consequently, when the storage device 30' of Fig. 4B is temporarily connected to the bit line 10A and the complementary bit line 10B in their precharged state by means of the switching transistors 36A, 36B, the complementary bit line 10B is connected to the high voltage potential provided at supply node 31. Therefore, no voltage drop occurs at the complementary bit line 10B.

If the additional connection is provided from the node 39 to the low voltage potential as shown in Fig. 4B, gates of the transistors 32A and 34A are also connected to the low voltage potential and transistor 32A is in an open state while transistor 34A is in a closed state. Consequently, when the storage device 30" of Fig. 4B is temporarily connected to the bit line 10A and the complementary bit line 10B in their precharged state by means of the switching transistors 36A, 36B, the bit line 10A is connected to the high voltage potential provided at supply node 31. Therefore, no voltage drop occurs at the bit line 10A.

As can be seen from the above, by providing the additional connection, the storage device 30 is modified such that a read operation on the corresponding memory cell always provides a predetermined result or information.

The approach of physically modifying the semiconductor circuit of the storage device by a metalization step is considered to be particularly advantageous as it can be achieved by providing a single mask for the metalization. This simplifies the total production process and further facilitates providing a memory device with modified permanently stored information, for example when producing a microprocessor with updated data stored in ROM.

The present invention is not limited to establishing a connection to the low voltage potential or ground potential. The particular modifications which have to be achieved in the additional process step, however, depend on the detailed structure of the used memory cells. For example, in the exemplary memory cell of Figs. 3, 4A and 4B, the predetermined information could also be assigned to the memory cell by establishing a connection from the node 38 or 39 to the high voltage potential, only that then for a logic "0" node 39 would have to be connected to the high voltage potential, and for a logic "1" node 38 would have to be connected to the high voltage potential.

## Claims

1. A method for producing a hybrid SRAM/ROM memory device, comprising the steps of
providing memory cells (2, 4) each comprising a storage device (30, 30', 30'') with a semiconductor circuit designed for storing information in said memory cell, wherein the storage device (30) of each memory cell comprises a bistable semiconductor circuit which is connected between a bit line (10A) and a complementary bit line (10B) via switching transistors (36A, 36B),
physically modifying the semiconductor circuit of the storage devices (30', 30") of at least one of the memory cells (4) in an additional process step to assign predetermined information to said memory cell (4) such that said modified memory cell (4) corresponds to a ROM cell from which the predetermined information can permanently be retrieved in a read operation,
wherein the modifying step comprises establishing an additional connection in said modified memory cell (4) as compared to the unmodified memory cells (2),
**characterized in that** the additional connection either connects a node (38) between the switching transistor (36A) of the bit line (10A) and the bistable semiconductor circuit or a node (39) between the switching transistor (36B) of the complementary bit line (10B) and the bistable semiconductor circuit to a low voltage potential or a high voltage potential,
and the unmodified memory cells (2) correspond to SRAM cells in which the information can be stored in a write operation and from which the information can be retrieved in said read operation.

2. A method according to claim 1,
**characterized in that**
said modifying step comprises providing a metalization to the memory device for establishing the additional connection.

3. A method according to any one of the preceding claims,
**characterized in that**
said modifying step comprises selectively doping semiconductor material of the memory device for establishing the additional connection.

4. A hybrid SRAM/ROM memory device comprising
memory cells (2, 4) for storing information,
wherein each of the memory cells (2, 4) comprises a storage device (30, 30', 30'') with a semiconductor circuit designed for storing information in said memory cell,
wherein the storage device (30) of each memory cell comprises a bistable semiconductor circuit which is connected between a bit line (10A) and a complementary bit line (10B) via switching transistors (36A, 36B),
wherein for at least one of the memory cells (4) the semiconductor circuit of the respective storage device (30', 30'') is modified in an additional process step so as to comprise an additional connection as compared to the unmodified memory cells (2) in order to assign predetermined information to said modified memory cell (4), such that said modified memory cell (4) corresponds to a ROM cell from which the predetermined information can permanently be retrieved in a read operation,
**characterized in that**
the additional connection either connects a node between the switching transistor (36A) of the bit line (10A) and the bistable semiconductor circuit or a node between the switching transistor (36B) of the complementary bit line (10B) and the bistable semiconductor circuit to a low voltage potential or a high voltage potential, wherein
the unmodified memory cells (2) correspond to SRAM cells in which the information can be stored in a write operation and from which the information can be retrieved in a read operation.

5. A memory device according to claim 4, comprising
a read device (7) for performing said read operation, and
a write device (8) for performing said write operation
**characterized in that** the read device (7) and the write device (8) address all memory cells (2, 4) of the memory device.

6. A memory device according to claim 4 or 5,
**characterized in that**
the memory device is produced using a method according to any one of claims 1 to 3.

## Patentansprüche

1. Verfahren zur Herstellung einer hybriden SRAM/ROM-Speichervorrichtung, umfassend die Schritte:
Bereitstellen von Speicherzellen (2, 4), welche jeweils eine Speichervorrichtung (30, 30', 30") mit einer Halbleiterschaltung umfassen, welche dazu ausgestaltet ist, Informationen in der Speicherzelle zu speichern, wobei die Speichervorrichtung (30) jeder Speicherzelle eine bistabile Halbleiterschaltung umfasst, welche über Schalttransistoren (36A, 36B) zwischen eine Bitleitung (10A) und eine komplementäre Bitleitung (10B) geschaltet ist,
physikalisches Modifizieren der Halbleiterschaltung der Speichervorrichtungen (30', 30") von wenigstens einer der Speicherzellen (4) in einen zusätzlichen Prozessschritt, um der Speicherzelle (4) vorbestimmte Informationen zuzuweisen, so dass die modifizierte Speicherzelle (4) einer ROM-Zelle entspricht, aus welcher die vorbestimmten Informationen in einem Lesevorgang permanent abgerufen werden können,
wobei der Modifikationsschritt umfasst, dass in der modifizierten Speicherzelle (4) im Vergleich zu den nicht modifizierten Speicherzellen (2) eine zusätzliche Verbindung hergestellt wird,
**dadurch gekennzeichnet,**
**dass** die zusätzliche Verbindung entweder einen Knotenpunkt (38) zwischen dem Schalttransistor (36A) der Bitleitung (10A) und der bistabilen Halbleiterschaltung oder einen Knotenpunkt (39) zwischen dem Schalttransistor (36B) der komplementären Bitleitung (10B) und der bistabilen Halbleiterschaltung mit einem niedrigen Spannungspotenzial oder einem hohen Spannungspotenzial verbindet, und
**dass** die unmodifizierten Speicherzellen (2) SRAM-Zellen entsprechen, in welchen die Informationen in einem Schreibvorgang gespeichert werden können und aus welchen die Informationen in dem Lesevorgang abgerufen werden können.

2. Verfahren nach Anspruch 1,
**dadurch gekennzeichnet,**
**dass** der Modifikationsschritt umfasst, dass die Speichervorrichtung mit einer Metallisierung versehen wird, um die zusätzliche Verbindung herzustellen.

3. Verfahren nach einem der vorhergehenden Ansprüche,
**dadurch gekennzeichnet,**
**dass** der Modifikationsschritt umfasst, dass Halbleitermaterial der Speichervorrichtung selektiv dotiert wird, um die zusätzliche Verbindung herzustellen.

4. Hybride SRAM/ROM-Speichervorrichtung, umfassend
Speicherzellen (2, 4) zur Speicherung von Informationen,
wobei jede der Speicherzellen (2, 4) eine Speichervorrichtung (30, 30', 30" ) mit einer Halbleiterschaltung umfasst, welche dazu ausgestaltet ist, Informationen in der Speicherzelle zu speichern,
wobei die Speichervorrichtung (30) jeder Speicherzelle eine bistabile Halbleiterschaltung umfasst, welche über Schalttransistoren (36A, 36B) zwischen eine Bitleitung (10A) und eine komplementäre Bitleitung (10B) geschaltet ist,
wobei für wenigstens eine der Speicherzellen (4) die Halbleiterschaltung der entsprechenden Speichervorrichtung (30', 30") in einem zusätzlichen Prozessschritt modifiziert ist, so dass sie im Vergleich zu den nicht modifizierten Speicherzellen (2) eine zusätzliche Verbindung umfasst, um der modifizierten Speicherzelle (4) vorbestimmte Informationen zuzuweisen, so dass die modifizierte Speicherzelle (4) einer ROM-Zelle entspricht, aus welcher die vorbestimmten Informationen in einem Lesevorgang permanent abgerufen werden können,
**dadurch gekennzeichnet,**
**dass** die zusätzliche Verbindung entweder einen Knotenpunkt zwischen dem Schalttransistor (36A) der Bitleitung (10A) und der bistabilen Halbleiterschaltung oder einen Knotenpunkt zwischen dem Schalttransistor (36B) der komplementären Bitleitung (10B) und der bistabilen Halbleiterschaltung mit einem niedrigen Spannungspotenzial oder einem hohen Spannungspotenzial verbindet,
wobei die unmodifizierten Speicherzellen (2) SRAM-Zellen entsprechen, in welchen die Informationen in einem Schreibvorgang gespeichert werden können und aus welchen die Informationen in einem Lesevorgang abgerufen werden können.

5. Speichervorrichtung nach Anspruch 4, umfassend
eine Lesevorrichtung (7) zur Durchführung des Lesevorgangs, und
eine Schreibvorrichtung (8) zur Durchführung des Schreibvorgangs,
**dadurch gekennzeichnet,**
**dass** die Lesevorrichtung (7) und die Schreibvorrichtung (8) alle Speicherzellen (2, 4) der Speichervorrichtung adressieren.

6. Speichervorrichtung nach Anspruch 4 oder 5,
**dadurch gekennzeichnet,**
**dass** die Speichervorrichtung unter Verwendung eines Verfahrens gemäß einem der Ansprüche 1-3 hergestellt ist.

## Revendications

1. Procédé de fabrication d'un dispositif hybride de mémoire SRAM/ROM comprenant les stades dans lesquels,
on se procure des cellules (2, 4) de mémoire, chacune comprenant un dispositif (30, 30', 30") de mémorisation ayant un circuit à semi-conducteur conçu pour mémoriser de l'information dans la cellule de mémoire, le dispositif (30) de mémorisation de chaque cellule de mémoire comprenant un circuit bistable à semi-conducteur, qui est monté entre une ligne (10A) de bit et une ligne (10B) de bit complémentaire par l'intermédiaire de transistor (36A, 36B) de commutation,
on modifie physiquement le circuit à semi-conducteur du dispositif (30', 30") de mémorisation d'au moins l'une des cellules (4) de mémoire dans un stade opératoire supplémentaire pour affecter de l'information déterminée à l'avance à ladite cellule (4) de mémoire de façon à ce que ladite cellule (4) de mémoire modifiée corresponde à une cellule ROM dans laquelle l'information déterminée à l'avance peut être retrouvée en permanence dans une opération de lecture,
dans lequel le stade de modification comprend l'établissement d'une connexion supplémentaire dans la cellule (4) de mémoire modifiée par rapport aux cellules (2) de mémoire non modifiées,
**caractérisé en ce que** la connexion supplémentaire soit connecte un noeud (38) entre le transistor (36A) de commutation de la ligne (10A) de bit et le circuit bistable à semi-conducteur, soit un noeud (39) entre le transistor (36B) de commutation de la ligne (10B) de bit complémentaire et le circuit bistable à semi-conducteur à un potentiel de tension bas ou un potentiel de tension haut et les cellules (2) de mémoire non modifiées correspondent à des cellules SRAM dans lesquelles l'information peut être mémorisées dans une opération d'écriture et dans lesquelles l'information peut être retrouvée dans ladite opération de lecture.

2. Procédé suivant la revendication 1, dans lequel dans le stade de modification il est prévu une métallisation du dispositif de mémoire pour établir la connexion supplémentaire.

3. Procédé suivant l'une quelconque des revendications précédentes, **caractérisé en ce que** le stade de modification comprend le dopage sélectif de matière semi-conductrice du dispositif de mémoire pour établir la connexion supplémentaire.

4. Dispositif hybride de mémoire SRAM/ROM, comprenant des cellules (2, 4) de mémoire pour mémoriser de l'information,
dans lequel chacune des cellules (2, 4) de mémoire comprend un dispositif (30, 30', 30") de mémorisation ayant un circuit à semi-conducteur conçu pour mémoriser de l'information dans la cellule de mémoire,
dans lequel le dispositif (30) de mémorisation de chaque cellule de mémoire comprend un circuit bistable à semi-conducteur, qui est monté entre une ligne (10A) de bit et une ligne (10B) de bit complémentaire par l'intermédiaire de transistor (36A, 36B) de commutation,
dans lequel, pour au moins l'une des cellules (4) de mémoire, le circuit à semi-conducteur du dispositif (30', 30") respectif de mémorisation est modifié dans un stade opératoire supplémentaire de manière à comprendre une connexion supplémentaire par rapport aux cellules (2) de mémoire non modifiées afin d'affecter de l'information déterminée à l'avance à la cellule (4) de mémoire modifiée, de façon à ce que la cellule (4) de mémoire modifiée corresponde à une cellule ROM dans laquelle l'information déterminée à l'avance peut être retrouvée en permanence dans une opération de lecture,
**caractérisé en ce que** la connexion supplémentaire soit connecte un noeud entre le transistor (36A) de commutation de la ligne (10A) de bit et le circuit bistable à semi-conducteur, soit un noeud entre le transistor (36B) de commutation de la ligne (10B) de bit complémentaire et le circuit à bistable à semi-conducteur à un potentiel à basse tension ou à un potentiel à haute tension, dans lequel les cellules (2) de mémoire non modifiées correspondent à des cellules SRAM dans lesquelles l'information peut être mémorisée dans une opération d'écriture et dans lesquelles l'information peut être retrouvée dans une opération de lecture.

5. Dispositif de mémoire suivant la revendication 4, comprenant un dispositif (7) de lecture pour effectuer l'opération de lecture et un dispositif (8) d'écriture pour effectuer l'opération de lecture, **caractérisé en ce que** le dispositif (7) de lecture et le dispositif (8) d'écriture adressent toutes les cellules (2, 4) de mémoire du dispositif de mémoire.

6. Dispositif de mémoire suivant la revendication 4 ou 5, **caractérisé en ce que** le dispositif de mémoire est fabriqué en utilisant un procédé suivant l'une quelconque des revendications 1 à 3.
